(19) Europäisches Patentamt

European Patent Office

Office européen des brevets

(11) **EP 2 587 377 A2**

(12) **EUROPEAN PATENT APPLICATION**

(43) Date of publication:
**01.05.2013   Bulletin 2013/18**

(51) Int Cl.:
*G06F 11/10* ^(2006.01)

(21) Application number: **12188823.4**

(22) Date of filing: **17.10.2012**

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br>Designated Extension States:<br>**BA ME**<br><br>(30) Priority: **24.10.2011  KR 20110108886** | (71) Applicant: **Samsung Electronics Co., Ltd**<br>**Gyeonggi-do 443-742 (KR)**<br><br>(72) Inventor: **Cho, Dong Seok**<br>**Seoul (KR)**<br><br>(74) Representative: **Grünecker, Kinkeldey,**<br>**Stockmair & Schwanhäusser**<br>**Leopoldstrasse 4**<br>**80802 München (DE)** |

(54) **Memory system and method for recording/reproducing data thereof**

(57)   A memory system and a method for recording/reproducing data thereof, the memory system including a flash memory, and a memory controller configured control an operation to record data on the flash memory or to reproduce the recorded data from the flash memory, wherein the memory controller includes an encoder configured to generate an Error Correction Code (ECC) from data that is to be recorded in the flash memory and to convert the generated ECC by using a particular ECC, a memory interface configured to record the data and the converted ECC to the flash memory, and a decoder configured to restore the converted ECC, which is read from the flash memory, by using the particular ECC and to detect and correct an error of the data, which is read from the flash memory, by using the restored ECC, and the particular ECC is an ECC with respect to 0xff data.

FIG. 3

**EP 2 587 377 A2**

**Description**

BACKGROUND

1. Field

Embodiments of the present disclosure relate to a memory system capable of detecting and correcting an error of data stored in a flash memory, and a method for recording/reproducing data thereof.

2. Description of the Related Art

A flash memory is a non-volatile memory provided with no need for an electrical power to maintain information at an inside a memory chip therein. Moreover, although not as fast as a DRAM that is used as a main memory in a PC, the flash memory is provided with faster reading speed and is stronger against impact when compared to a hard disc. Due to these features, the flash memory is being widely used as a storage apparatus in a device that is operated by a battery. Another feature of the flash memory apparatus is that the flash memory apparatus is not as nearly being destroyed by a physical means, as the flash memory apparatus is capable of tolerating a strong pressure and boiling water.

The flash memory is referred to as a non-volatile computer memory apparatus capable of electrically erasing and rewriting date therein. Different from an Electrically Erasable and Programmable ROM (EEPROM), the flash memory apparatus is capable of erasing and writing data in block units. The flash memory apparatus is provided with less cost when compared to the EEPROM, thereby is mainly used when a high-capacity storage, which is non-volatile and is in a solid state, is needed.

As a typical example of the flash memory apparatus in use, digital music players, digital cameras, or handheld phone devices may be included. An USB drive is used in many occasions for a using storing general data and moving data in between computers, and the flash memory apparatus is being used at the time as such.

In addition, the flash memory is divided into a data region in which (main) data is being stored and a spare region in which basic information, which is supplementary, is being stored. The spare region in general is provided with basic information, such as an Error Correction Code (hereinafter called ECC), information on bad blocks, and data related to a file system, stored therein.

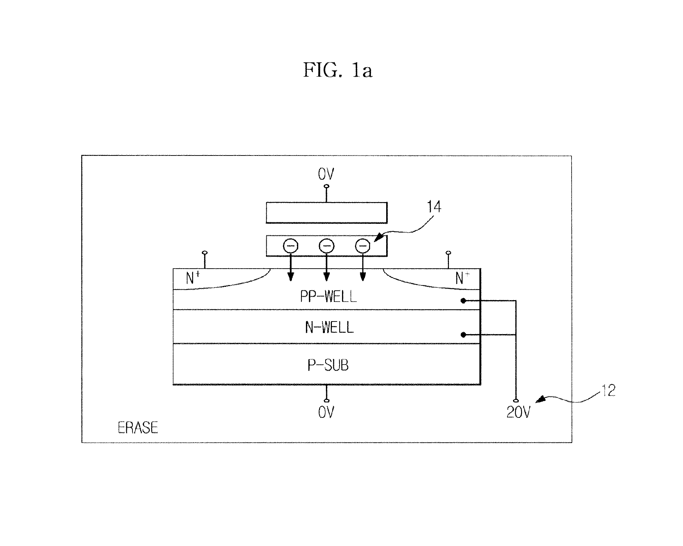

FIGS. 1A to 1C are drawings to describe the operation of the flash memory.

In general, the flash memory is operated by three operations of ERASE, WRITE or PROGRAM or READ.

The ERASE operation of the flash memory is performed in block units, and represents the changing of a cell from 0 to 1. As illustrated on FIG. 1A, in order to perform the ERASE operation, a voltage of 20V is applied at a substrate (12), the electrons at a floating gate are moved toward a lower direction thereof by the F-N Tunneling effect (14).

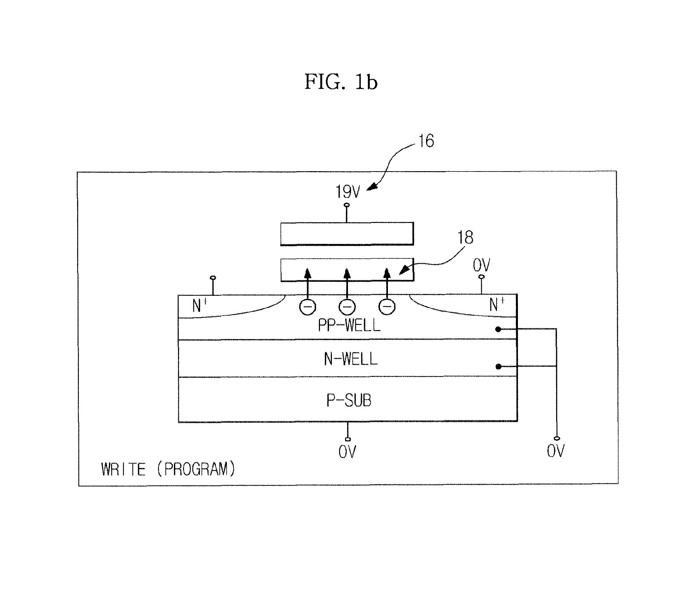

The WRITE, that is, PROGRAM, operation of the flash memory represents the changing of the cell from 1 to 0 while performing such in byte or page units. As illustrated on FIG. 1B, when a voltage of 19V is applied to the gate of each cell (16), the electrons are moved in a direction toward the floating gate (18). At this time, the state of the cell becomes the state of OFF Tr, and thus becomes the state of Vt (+). The WRITE operation is not being completed on a single occasion, but performs the PROGRAM of the desired data by increasing the voltage value in multiple stages.

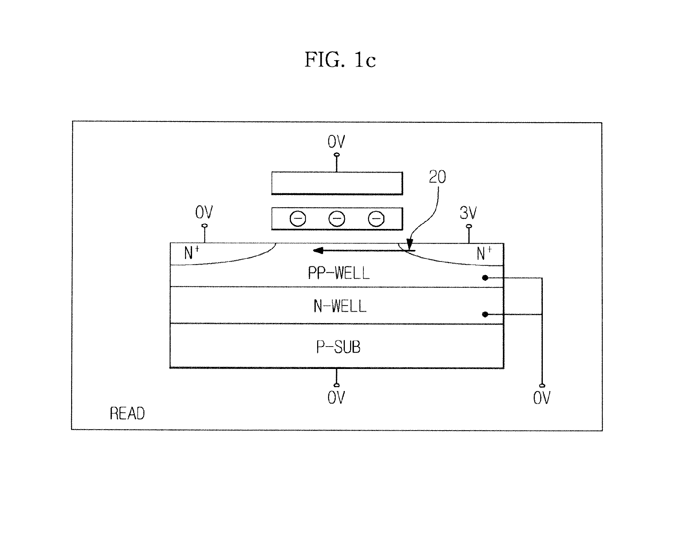

The READ operation of the flash memory, as illustrated on FIG. 1C, is referred to as the operation (20) that is configured to check whether the state of the cell is ON Tr or OFF Tr, and outputs the data as 1 or 0. The cell at the flash memory is applied with a stress increasing in the order of ERASE, WRITE, and READ, and after a particular level of the stress is applied, the flash memory is reached to a level at which the flash memory is no longer usable, and as such is referred to as the state of WEAR-OUT of the flash memory.

Meanwhile, the flash memory, due to the unique features thereof, may be provided with bit errors occurred therein, and the detecting and correcting the error are needed. For such, an error correcting code (ECC) is used. When the data is recorded to the flash memory or read (reproduced) from the flash memory, an ECC on a data to be recorded or on a data having been read is generated by using a particular ECC Algorithm, and the WRITE(RECORD) and READ (REPRODUCE) operation are performed by using the generated ECC.

Here, if 0xff data is recorded on the data region of the flash memory, due to the unique features of the flash memory, REWRITE may be possible to the flash memory without having to erase the 0xff data that is recorded, but if an ECC generated with respect to the 0xff data is not an 0xff ECC, a corresponding block is needed to be erased in order to perform the REWRITE to the flash memory. However, a frequent 'erase' operation with respect to the flash memory reduces the lifespan of the flash memory and the recording performance of the flash memory.

SUMMARY

Therefore, it is an aspect of the present disclosure to provide a memory system capable of enhancing a recording performance of a flash memory while extending the lifespan of the flash memory by reducing the number of erase operations on the flash memory, and a method for recording/reproducing data thereof.

It is another aspect of the present disclosure to provide a memory system capable of generating 0xff ECC with respect to 0xff data by adding a relatively simple operation process regardless of the type of an ECC algorithm, and a method for recording/reproducing data thereof.

Additional aspects of the disclosure will be set forth in part in the description which follows and, in part, will be apparent from the description, or may be learned by practice of the disclosure.

In accordance with one aspect of the present disclosure, a memory system including a flash memory and a memory controller configured to control an operation to record data on the flash memory or to reproduce the recorded data from the flash memory. The memory controller may include an encoder, a memory interface and a decoder. The encoder may be configured to generate an Error Correction Code (ECC) from data that is to be recorded in the flash memory and to convert the generated ECC by using a particular ECC. The memory interface may be configured to record the data and the converted ECC to the flash memory. The decoder may be configured to restore the converted ECC, which is read from the flash memory, by using the particular ECC and to detect and correct an error of the data, which t is read from the flash memory, by using the restored ECC. The particular ECC may be an ECC with respect to 0xff data.

The encoder may include an ECC generating unit configured to generate an ECC from input data that is to be recorded in the flash memory, and an ECC converting unit configured to convert the generated ECC by using the particular ECC.

The decoder may include an ECC restoring unit configured to restore the converted ECC, which is read from the flash memory, by using the particular ECC, and an error detecting/correcting unit configured to detect and correct an error of the data, which is read from the flash memory, by using the restored ECC.

The encoder may convert the generated ECC by using Mathematical Formula 1 below, wherein

[Mathematical Formula 1]

Converted ECC = [Generated ECC] XOR [ECC with respect to 0xff data].

The decoder may restore the converted ECC, which is read from the flash memory, by using Mathematical Formula 2 below, wherein

[Mathematical Formula 2]

Restored ECC = [Converted ECC] XOR [ECC with respect to 0xff data].

The decoder may further include an ECC generating unit configured to generate an ECC from the recorded data that is read from the flash memory, and a comparison unit configured to compare the ECC generated from the recorded data with the restored ECC.

The error detecting/correcting unit, if the ECC generated from the recorded data is identical to the restored ECC as a result of a comparison by the comparison unit, may detect and correct an error of the data, which is read from the flash memory, by using the ECC generated from the recorded data and the restored ECC.

The flash memory may be one of a NAND flash memory, a NOR flash memory, and a Magnetic Random Access Memory (MRAM).

In accordance with another aspect of the present disclosure, a memory system includes a flash memory and a memory controller that is configured to control an operation to record data on the flash memory or to reproduce the recorded data from the flash memory. The memory controller may include an encoder, a memory interface and a decoder. The encoder may be configured to generate an Error Correction Code (ECC) from data that is to be recorded in the flash memory and to convert the generated ECC by using a particular ECC. The memory interface may be configured to record the data and the converted ECC to the flash memory ECC. The decoder may be configured to restore converted ECC, which is read from the flash memory, by using the particular ECC and to detect and correct an error of the data, which is read from the flash memory, by using the restored ECC. The flash memory may include a data region and a spare region. The data may be stored in the data region and the converted ECC may be stored in the spare region.

The particular ECC may be an ECC with respect to 0xff data.

In accordance with another aspect of the present disclosure, a method for recording/reproducing data of a memory system having a flash memory is as follows. Data may be recorded in the flash memory. An ECC may be generated from the recorded data. The generated ECC may be converted by using a particular ECC. The converted ECC may be converted to the flash memory. The recorded data may be read from the flash memory. An ECC may be generated from the recorded data that is read from the flash memory. The converted ECC may be read from the flash memory. The converted ECC may be restored by using the particular ECC. An error of the recorded data, which is read from the flash memory, may be detected and corrected by using the restored ECC. The particular ECC may be an ECC with respect to 0xff data.

The converting of the generated ECC may be performed by using Mathematical Formula 1 below, wherein

[Mathematical Formula 1]

$$\text{Converted ECC} = [\text{Generated ECC}] \text{ XOR } [\text{ECC with respect to 0xff data}].$$

The restoring of the converted ECC may be performed by using Mathematical Formula 2 below wherein

[Mathematical Formula 2]

$$\text{Restored ECC} = [\text{Converted ECC}] \text{ XOR } [\text{ECC with respect to 0xff data}].$$

The method may further include comparing the ECC generated from the recorded data with the restored ECC. The detecting and correcting of an error of the recorded data, which is read, may be performed when the ECC generated from the recorded data is not identical to the restored ECC as a result of a comparison.

The flash memory may be one of a NAND flash memory, a NOR flash memory, and a Magnetic Random Access Memory (MRAM).

The flash memory may include a data region and a spare region, and the data may be stored in the data region and the converted ECC may be stored in the spare region.

In accordance with another aspect of the present disclosure, a method for recording/reproducing data of a memory system having a flash memory, the method is as follows. Data may be recorded in the flash memory. An ECC may be generated from the recorded data. The generated ECC may be converted by using a particular ECC. The converted ECC may be recorded to the flash memory. The particular ECC may be an ECC with respect to 0xff data.

The converting of the generated ECC may be performed by using Mathematical Formula 1 below wherein

[Mathematical Formula 1]

$$\text{Converted ECC} = [\text{Generated ECC}] \text{ XOR } [\text{ECC with respect to 0xff data}].$$

The flash memory may include a data region and a spare region, and the data may be stored in the data region and the converted ECC may be stored in the spare region.

In accordance with another aspect of the present disclosure, a method for recording/reproducing data of a memory system having a flash memory, the method is as follows. A recorded data may be read from the flash memory. An ECC may be generated from the recorded data that is read from the flash memory. The converted ECC may be read from the flash memory. The converted ECC may be restored by using a particular ECC. An error of the recorded data, which is read from the flash memory, may be detected and corrected by using the restored ECC.

The particular ECC may be an ECC with respect to 0xff data.

The restoring of the converted ECC may be performed by using Mathematical Formula 2 below wherein

[Mathematical Formula 2]

Restored ECC = [Converted ECC] XOR [ECC with respect to 0xff data].

The method may further include comparing the ECC generated from the recorded data with the restored ECC. The detecting and correcting of an error of the recorded data, which is read from the flash memory, may be performed when the ECC generated from the recorded data is not identical to the restored ECC as a result of a comparison.

According to the suggested memory system and method for recording/reproducing data thereof, by reducing the number of erase operations on the flash memory, the lifespan of the flash memory may be extended while enhancing a recording performance of the flash memory.

In addition, according to the suggested memory system and method for recording/reproducing data thereof, by adding a relatively simple operation process regardless of the type of an ECC algorithm, 0xff ECC with respect to 0xff data may be generated.

BRIEF DESCRIPTION OF THE DRAWINGS

These and/or other aspects of the disclosure will become apparent and more readily appreciated from the following description of embodiments, taken in conjunction with the accompanying drawings of which:

FIGS. 1A to 1C are drawings to describe the operation of a flash memory.

FIG. 2 is a control block diagram of a memory system in accordance with an embodiment of the present disclosure.

FIG. 3 is a drawing showing the structure of an ECC controlling device illustrated on FIG. 2.

FIG. 4 is a drawing to describe the data format of the data recorded in the flash memory and the data read from the flash memory.

FIG. 5 is a flow chart illustrating a method for recording data of a memory system in accordance with an embodiment of the present disclosure.

FIG. 6 is a flow chart illustrating a method for reproducing data of a memory system in accordance with an embodiment of the present disclosure.

DETAILED DESCRIPTION

Reference will now be made in detail to embodiments of the present disclosure, examples of which are illustrated in the accompanying drawings, wherein like reference numerals refer to like elements throughout.

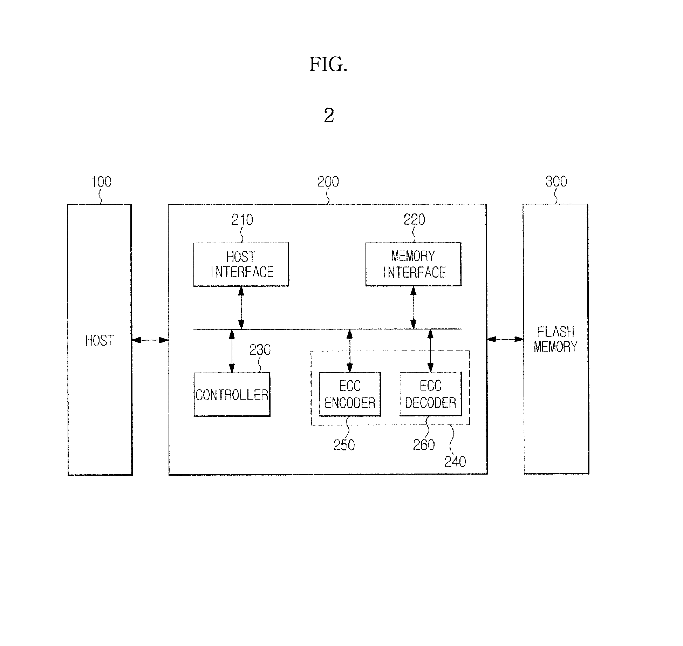

FIG. 2 is a control block diagram of a memory system in accordance with an embodiment of the present disclosure.

As illustrated on FIG. 2, a memory system in accordance with an embodiment of the present disclosure includes a memory controller 200 and a flash memory 300. The flash memory 300 is configured to operate according to the control of the main controller 200, and to store M-bit data information per cell. The M-bit data information may include 2-bit data, 3-bit data, and 4-bit data, for example. The flash memory 300 may be embodied with a NAND flash memory, a NOR flash memory, a Phase Change Random Access Memory (PRAM), a Magnetic Random Access Memory (MRAM), or a non-volatile memory.

The memory controller 200, by a request of a host 100, is configured to control the flash memory 300. The memory controller 200 includes a host interface 210, a memory interface 220, a controller 230, and an ECC controlling device 240. The host interface 210 is configured to provide an interface with the host 100, and the memory interface 220 is configured to provide an interface with the flash memory 300. The controller 230 may be implemented by a processor that is configured to control an overall operation of the memory controller 200. The host 100 and the memory controller 200 are configured in a way to communicate through various communication interfaces such as a Peripheral Component Interconnect (PCI) and a Universal Serial Bus (USB).

The memory controller 200 and the flash memory 300 are configured in a way to communicate through a widely known method such as a NAND/NOR interface scheme. The memory system that includes the memory controller 200 and the flash memory 300 may be a memory card such as a flash memory card and a smart card.

The ECC controlling device 240, by using an algorithm of a particular ECC, generates an Error Correction Code (ECC) with respect to data that is to be stored in the flash memory 300. The ECC is used for detecting and/or correcting an error. The ECC controlling device 240 performs the detection and correction of the error with respect to the data that is read from the flash memory 300. In particular, the ECC controlling device 240 at an inside of the memory system of an embodiment of the present disclosure generates an ECC from data that is to be recorded to the flash memory 300, and converts the generated ECC by using a particular ECC. The data, which is desired to be stored by a user, and the converted ECC, both of which are intended to be stored by a user, are stored in the flash memory 300. The ECC controlling device 240, by using the particular ECC, restores the converted ECC, which is read from the flash memory 300, by the particular ECC, and detects/corrects an error of the data, which is read from the flash memory 300, by using the restored ECC.

The ECC controlling device 240 in accordance with an embodiment of the present disclosure includes an ECC encoder 250 configured to generate an ECC from the data, which is to be recorded, and to convert the generated ECC by using the particular ECC and a decoder 260 configured to restore the converted ECC, which is read from the flash memory 300, by using the particular ECC, and to detect and correct the error of the data that is read from the flash memory 300 by using the restored ECC. Here, the particular ECC represents an ECC with respect to 0xff data.

The ECC controlling device 240 generates an ECC from the data that is to be recorded to the flash memory 300, and converts the ECC, which is generated from the data that is to be recorded, through an exclusive OR (XOR) of the generated ECC and an ECC for 0xff data generated by using an ECC algorithm being used at the memory system. In addition, the ECC controlling device 240 is configured to restore the ECC, which is converted at the process of recording the data, through an exclusive OR (XOR) of the converted ECC, which is converted and stored at the process of recording the data, and an ECC, which is related to 0xff data generated by using the ECC algorithm being used at the memory system. Then, an error of the data read from the flash memory 300 is detected and corrected by using the restored ECC.

As described above, the ECC controlling device 240 at an inside the memory system in accordance with an embodiment of the present disclosure converts the ECC, which generated from the data that is to be recorded, through the exclusive OR (XOR) of the generated ECC and the ECC which corresponds to 0xff data. In addition, the ECC controlling device 240 restores the converted ECC through the exclusive OR (XOR) of the converted ECC and the ECC with respect to 0xff data. Through the correction scheme as such, by reducing the number of erase operations on the flash memory as the ECC of 0xff is generated with respect to the 0xff data by adding a relatively simple operation process (XOR), the lifespan of the flash memory may be extended while enhancing a recording performance of the flash memory.

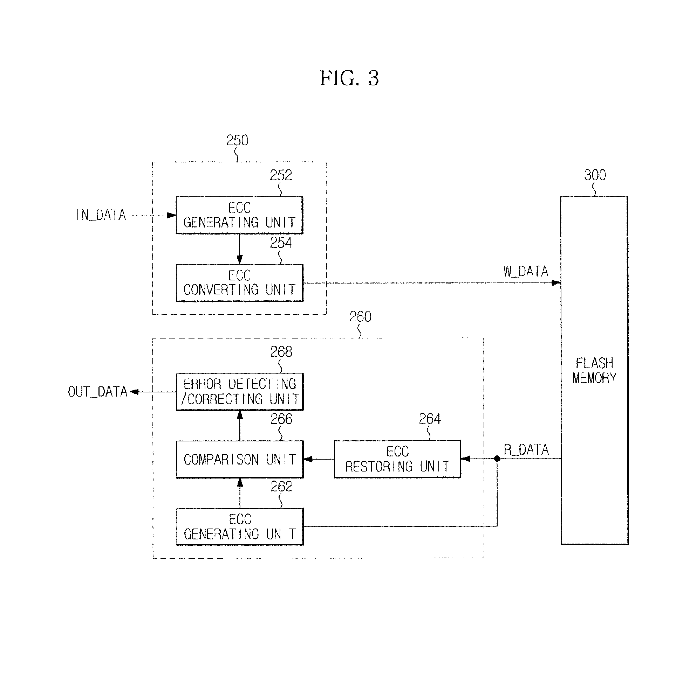

FIG. 3 is a drawing showing the structure of an ECC controlling device illustrated on FIG. 2.

As illustrated on FIG. 3, the ECC controlling device 240 includes the ECC encoder 250 and the ECC decoder 260. The ECC encoder 250 includes an ECC generating unit 252 to generate an ECC with respect to data that is to be stored at the flash memory 300, and an ECC converting unit 254 to convert the ECC, which is generated through the ECC generating unit 252, by using a particular ECC, that is, an ECC with respect to 0xff data.

The ECC generating unit 252 generates an ECC with respect to data, which is to be recorded, by receiving program data (IN_DATA) and using a particular ECC algorithm. The ECC generating unit 252 is configured to generate a linear code as an ECC, and some of the examples of the linear code may include repetition codes, parity codes, cyclic codes, Hamming code, Golay code, RS code (Reed-Solomoncodes), BCH code (Bose, Ray-Chaudhuri, Hocquenghem), and RM codes (Reed-Muller codes).

The ECC converting unit 254 is input with the generated ECC from the ECC generating unit 252, and uses Mathematical Formula 1 below, thereby converting the generated ECC.

[Mathematical Formula 1]

$$\text{Converted ECC} = [\text{Generated ECC}] \text{ XOR } [\text{ECC with respect to 0xff data}]$$

The converted ECC, which is output from the ECC converting unit 254, is added to the program data (IN_DATA) that is input from the host 100, and is stored at the flash memory 300 through the memory interface 220.

Meanwhile, as illustrated on FIG. 3, the ECC decoder 260 includes an ECC generating unit 262, an ECC restoring unit 264, a comparison unit 266 and an error detecting/correcting unit 268. The ECC generating unit 262 generates an ECC from the recorded data that is read from the flash memory 300. The ECC restoring unit 264 restores the ECC, which is converted at a process of recording the data and stored, by using a particular ECC (ECC with respect to 0xff data). The comparison unit 266 compares the ECC generated through the ECC generating unit 262 with the ECC restored through the ECC restoring unit 264. The error detecting/correcting unit 268 detects/corrects the error of the data, which is read from the flash memory 300, by using the restored ECC and the ECC generated through the ECC generating unit 262 according to the result of a comparison of the comparison unit 266.

The ECC generating unit 262 is input with data, that is, main data among read data (R-DATA) including the main data and the converted ECC, and generates an ECC, which is with respect to data that is to be reproduced, by using the same algorithm as the ECC algorithm that has been used in the recording process of the data.

The ECC restoring unit 264 is input with the converted ECC from the read data (R_DATA), and restores the converted ECC by using Mathematical Formula 2 below.

[Mathematical Formula 2]

$$\text{Restored ECC} = [\text{Converted ECC}] \text{ XOR } [\text{ECC with respect to 0xff data}]$$

The comparison unit 266 determines whether the ECC generated through the ECC generating unit 262 is identical to the restored ECC restored through the ECC restoring unit 264, and outputs the result of the determination to the error detecting/correcting unit 268.

The error detecting/correcting unit 268, when the ECC generated from the read data is not identical to the restored ECC as a result of the comparison, detects/corrects the error of the data read from the flash memory 300 by using the generated ECC through the ECC generating unit 262 and the restored ECC.

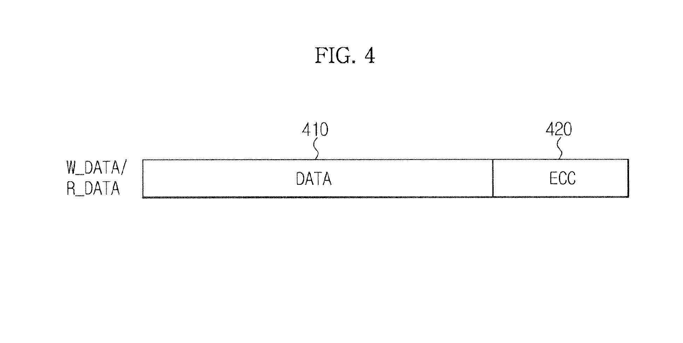

FIG. 4 is a drawing to describe the data format of the data recorded in the flash memory and the data read from the flash memory.

FIG. 4 shows the format of a write data (W_DATA) and the read data (R_DATA) that are respectively stored in and read from the flash memory 300 illustrated on FIG. 3.

The flash memory 300 includes a memory cell array that including at least two storage region. The first storage region is referred to a data region 410 at which (main) data that is transmitted from a host 100 is stored, and the second storage region is referred to a spare region 420 at which basic information, which is supplementary, such as an ECC for stored in the data region 410, is stored. As illustrated on FIG. 4, the (main) data that is transmitted from the host 100 is stored in the data region 410, and the ECC, in detail, a converted ECC with respect to the (main) data is stored in the spare region 420.

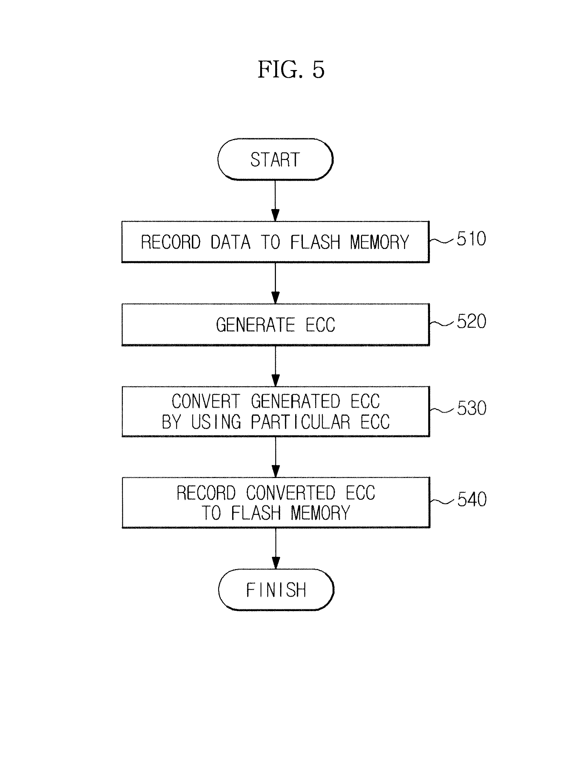

FIG. 5 is a flow chart illustrating a method for recording data of a memory system in accordance with an embodiment of the present disclosure.

As the program data (IN_DATA) is input, the memory interface 220 records the data to the data region 410 of the flash memory 300 (510).

The ECC generating unit 252 at an inside the ECC encoder 250 generates the ECC that is related to the data, which is being recorded at the flash memory 300, by using a particular algorithm (520).

The ECC converting unit 254 at an inside the ECC encoder 250, by using the particular ECC, that is, an ECC with respect to 0xff data, converts the ECC that is generated through the ECC generating unit 252 (530). The converted ECC is calculated by using Formula 1 below.

[Formula 1]

$$\text{Converted ECC} = [\text{Generated ECC}] \text{ XOR } [\text{ECC with respect to 0xff data}]$$

After the converted ECC is calculated through the ECC converting unit 254, the memory interface 220 records the converted ECC to the spare region 420 of the flash memory 300 (540).

Through the process described previously, the recording process on the flash memory 300 is completed, and the flash memory 300 is provided with the write data (W_DATA) recorded thereto, and the write data (W_DATA) includes the program data and the converted ECC that is generated by the ECC converting unit 254.

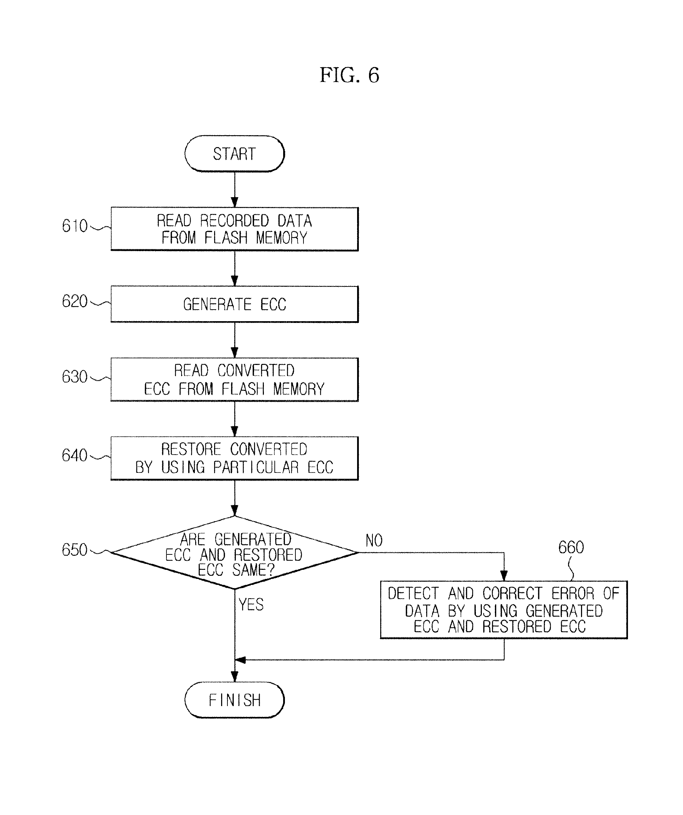

FIG. 6 is a flow chart illustrating a method for reproducing data of a memory system in accordance with an embodiment of the present disclosure.

The ECC decoder 260 reads the recorded data from the flash memory 300 (610). At this time, the read data (R_DATA) includes the program data and the converted ECC, which is generated through the ECC converting unit 254 at the time at the writing process.

The ECC generating unit 262 at an inside the ECC decoder 260 is input with the (main) data of the read data (R_DATA), and generates an ECC with respect to data, which is to be reproduced, by using the same algorithm as the ECC algorithm used in the recording process of the data (620).

The ECC decoder 260 reads the ECC, which is converted and stored at the recording process, from the flash memory 300 (630).

The ECC restoring unit 264 at an inside the ECC decoder 260, by using the particular ECC, that is, the ECC with respect to 0xff data, restores the ECC that is converted in the recording process (640). The restored ECC is calculated by using Formula 2 below.

[Formula 2]

Restored ECC= [converted ECC] XOR [ECC with respect to 0xff data]

The comparison unit 266 at an inside the ECC decoder 260 determines whether the ECC generated through the ECC generating unit 262 and the ECC restored through the ECC restoring unit 264 are the same (650). If the ECC generated through the ECC generating unit 262 and the ECC restored through the ECC restoring unit 264 are not the same, that is, if determined as 'NO' in operation 650, the error detecting/correcting unit 268, by using the ECC generated through the ECC generating unit 262 and the restored ECC, detects/corrects the error of the data that is read from the flash memory 300. The data having the error thereof corrected through the detecting/correcting unit 268 is transmitted to the host 100 through the host interface 210.

Meanwhile, if the generated ECC and the restored ECC are same, that is, if determined as 'YES' in operation 650, the ECC decoder 260 transmits the data, which is read from the flash memory 300, to the host 100 through the host interface 210.

Although a few embodiments of the present disclosure have been shown and described, it would be appreciated by those skilled in the art that changes may be made in these embodiments without departing from the principles and spirit of the disclosure, the scope of which is defined in the claims and their equivalents.

**Claims**

1. A memory system, comprising:

   a flash memory;
   and a memory controller configured to control an operation to record data on the flash memory or to reproduce the recorded data from the flash memory,
   wherein the memory controller, comprises:

   an encoder configured to generate an Error Correction Code (ECC) from data that is to be recorded in the flash memory and to convert the generated ECC using a particular ECC;
   a memory interface configured to record the data and the converted ECC to the flash memory; and
   a decoder configured to restore the converted ECC, which is read from the flash memory, using the particular ECC and to detect and correct an error of the data, which is read from the flash memory, using the restored ECC, and
   wherein the particular ECC is an ECC with respect to 0xff data.

2. The memory system of claim 1, wherein the encoder comprises:

   an ECC generating unit configured to generate an ECC from input data that is to be recorded in the flash memory; and
   an ECC converting unit configured to convert the generated ECC using the particular ECC.

3. The memory system of claim 1, wherein the decoder comprises:

an ECC restoring unit configured to restore the converted ECC, which is read from the flash memory, using the particular ECC; and
an error detecting/correcting unit configured to detect and correct an error of the data, which is read from the flash memory, using the restored ECC.

**4.** The memory system of claim 1, wherein the encoder converts the generated ECC by using Mathematical Formula 1 below, wherein

[Mathematical Formula 1]

Converted ECC = [Generated ECC] XOR [ECC with respect to 0xff data].

**5.** The memory system of claim 1, wherein the decoder restores the converted ECC, which is read from the flash memory, by using Mathematical Formula 2 below, wherein

[Mathematical Formula 2]

Restored ECC = [Converted ECC] XOR [ECC with respect to 0xff data].

**6.** The memory system of claim 3, wherein the decoder further comprises:

an ECC generating unit configured to generate an ECC from the recorded data that is read from the flash memory; and
a comparison unit configured to compare the ECC generated from the recorded data with the restored ECC.

**7.** The memory system of claim 6, wherein the error detecting/correcting unit, if the ECC generated from the recorded data is not identical to the restored ECC as a result of a comparison by the comparison unit, detects and corrects an error of the data, which is read from the flash memory, using the ECC generated from the recorded data and the restored ECC.

**8.** A method for recording/reproducing data of a memory system having a flash memory, the method comprising:

recording data in the flash memory;
generating an ECC from the recorded data;
converting the generated ECC using a particular ECC;
recording the converted ECC to the flash memory;
reading the recorded data from the flash memory;
generating an ECC from the recorded data that is read from the flash memory;
reading the converted ECC from the flash memory;
restoring the converted ECC using the particular ECC; and
detecting and correcting an error of the recorded data, which is read from the flash memory, using the restored ECC,
wherein the particular ECC is an ECC with respect to 0xff data.

**9.** The method of claim 8, wherein the converting of the generated ECC is performed by using Mathematical Formula 1 below, wherein

[Mathematical Formula 1]

Converted ECC = [Generated ECC] XOR [ECC with respect to 0xff data].

10. The method of claim 8, wherein the restoring of the converted ECC is performed by using Mathematical Formula 2 below wherein

[Mathematical Formula 2]

Restored ECC = [Converted ECC] XOR [ECC with respect to 0xff data].

11. The method of claim 8, further comprising:

comparing the ECC generated from the recorded data with the restored ECC, wherein the detecting and correcting of an error of the recorded data, which is read, is performed when the ECC generated from the recorded data is not identical to the restored ECC as a result of a comparison.

12. The method of claim 8, wherein the flash memory is one of a NAND flash memory, a NOR flash memory, and a Magnetic Random Access Memory (MRAM).

13. The method of claim 8, wherein the flash memory comprises a data region and a spare region, and
the data is stored in the data region and the converted ECC is stored in the spare region.

FIG. 1a

FIG. 1b

WRITE (PROGRAM)

FIG. 1c

FIG.

2

100                200                300

FIG. 3

FIG. 4

| DATA | ECC |
|------|-----|

W_DATA/
R_DATA

410 — DATA
420 — ECC

# FIG. 5

FIG. 6

```
                    ┌─────────────┐
                    │    START    │
                    └──────┬──────┘
                           │
                           ▼
           ┌───────────────────────────────┐
   610 ──  │     READ RECORDED DATA        │
           │      FROM FLASH MEMORY        │
           └───────────────┬───────────────┘
                           │
                           ▼
           ┌───────────────────────────────┐
   620 ──  │         GENERATE ECC          │
           └───────────────┬───────────────┘
                           │
                           ▼
           ┌───────────────────────────────┐
   630 ──  │        READ CONVERTED         │
           │     ECC FROM FLASH MEMORY     │
           └───────────────┬───────────────┘
                           │
                           ▼
           ┌───────────────────────────────┐
   640 ──  │       RESTORE CONVERTED       │
           │    BY USING PARTICULAR ECC    │
           └───────────────┬───────────────┘
                           │
                           ▼
                ╱─────────────────╲
   650 ──    ╱   ARE GENERATED      ╲   NO
            ⟨    ECC AND RESTORED    ⟩──────────────┐                660
             ╲     ECC SAME?       ╱                │
                ╲───────┬─────────╱                 ▼
                        │ YES           ┌───────────────────────────────┐
                        │               │ DETECT AND CORRECT ERROR OF   │
                        │               │  DATA BY USING GENERATED      │
                        │               │   ECC AND RESTORED ECC        │
                        │               └───────────────┬───────────────┘
                        │                               │
                        ▼◄──────────────────────────────┘
                 ┌─────────────┐
                 │   FINISH    │
                 └─────────────┘
```